# EUROPEAN PATENT APPLICATION

(11) **EP 4 841 632 A1**
(43) Date of publication of application: **18.11.2026**
(21) Application number: 26177113.3
(22) Date of filing: 07.05.2026
(51) Int. Cl.: G11C 7/10, G11C 11/4093, G11C 16/10, G11C 16/26

(54) **MEMORY DEVICE PROVIDING VARIABLE INPUT/OUTPUT AND METHOD PERFORMED BY MEMORY DEVICE**

(30) Priority: 14.05.2025 KR 20250062732; 30.10.2025 KR 20250160299
(71) Applicant: Samsung Electronics Co., Ltd., Suwon-si, Gyeonggi-do 16677 (KR)
(72) Inventor: CHOI, Yonghyuk, 16677 Suwon-si (KR); SONG, Seunghwan, 16677 Suwon-si (KR); KIM, Wandong, 16677 Suwon-si (KR)
(74) Representative: Marks & Clerk LLP

(57) **Abstract**

A memory device includes an input/output buffer configured to receive or output first data in a first mode and receive or output second data and third data in a second mode, a control circuit configured to obtain a first command-address in the first mode and obtain a second command-address and a third command-address in the second mode, and at least one pin connected to the input/output buffer and configured to receive or output at least one bit of the first data in the first mode and receive at least one bit of the third command-address in the second mode.

## Description

### FIELD

The present disclosure relates to a memory device, and more particularly, to a memory device providing variable input/output and a method performed by a memory device.

### BACKGROUND

A memory device may be used to store data in various applications and may update or output stored data in response to received commands. For example, the memory device may store data in response to a write command and may output stored data in response to a read command. An application may require sequential access to large amounts of data or may require fast access to scattered data. Accordingly, it may be important for the memory device to satisfy various requirements of the application.

### SUMMARY

A memory device according to aspects of the technical ideas of the present disclosure may include an input/output buffer configured to receive or output first data in a first mode and receive or output second data and third data in a second mode, a control circuit configured to obtain a first command-address in the first mode and obtain a second command-address and a third command-address in the second mode, and at least one first pin connected to the input/output buffer and configured to receive or output at least one bit of the first data in the first mode and receive at least one bit of the third command-address in the second mode.

A method performed by a memory device according to aspects of the technical idea of the present disclosure may include receiving a first command-address in a first mode, receiving or outputting first data based on the first command-address in the first mode, receiving a second command-address and a third command-address in a second mode, and receiving or outputting second data and third data based on the second command-address and the third command-address in the second mode. The receiving or outputting of the first data may include receiving or outputting at least one bit of the first data through at least one first pin. The receiving of the second command-address and the third command-address may include receiving at least one bit of the third command-address through the at least one first pin.

A memory device according to aspects of the technical idea of the present disclosure may include a plurality of input/output pins, an input/output buffer connected to the plurality of input/output pins, and a control circuit configured to control the input/output buffer according to a mode. The input/output buffer may be configured to receive or output at least one bit of data through at least one first input/output pin among the plurality of input/output pins in a first mode and receive at least one bit of a command-address through the at least one first input/output pin in a second mode.

At least some of the above and other embodiments of the invention are set out in the claims.

### BRIEF DESCRIPTION OF THE DRAWINGS

These and/or other aspects, features, and advantages of the disclosure will become apparent and more readily appreciated from the following description of example embodiments, taken in conjunction with the accompanying drawings of which:
FIGS. 1A and 1B are diagrams illustrating examples of a storage device according to example embodiments of the present disclosure;
FIGS. 2A and 2B are block diagrams illustrating examples of a memory device according to example embodiments of the present disclosure;
FIGS. 3A, 3B, 3C, and 3D are diagrams illustrating examples of a memory device according to example embodiments of the present disclosure;
FIGS. 4A, 4B, and 4C are timing diagrams illustrating examples of operations of a memory device according to example embodiments of the present disclosure;
FIGS. 5A and 5B are diagrams illustrating examples of a memory device according to example embodiments of the present disclosure;
FIGS. 6A and 6B are timing diagrams illustrating examples of operations of a memory device according to example embodiments of the present disclosure;
FIG. 7 illustrates a table showing modes of a memory device according to example embodiments of the present disclosure;
FIG. 8 is a block diagram illustrating a storage device according to example embodiments of the present disclosure;
FIG. 9 is a flowchart illustrating a method performed by a memory device according to example embodiments of the present disclosure;
FIGS. 10A and 10B are flowcharts illustrating examples of a method performed in a memory device according to example embodiments of the present disclosure;
FIG. 11 is a block diagram illustrating a storage device according to example embodiments of the present disclosure;
FIG. 12 is a block diagram illustrating a memory device according to example embodiments of the present disclosure; and
FIG. 13 is a block diagram illustrating a system according to example embodiments of the present disclosure.

### DETAILED DESCRIPTION

Technical ideas of the present disclosure provide a memory device providing variable input/output and a method performed thereby.

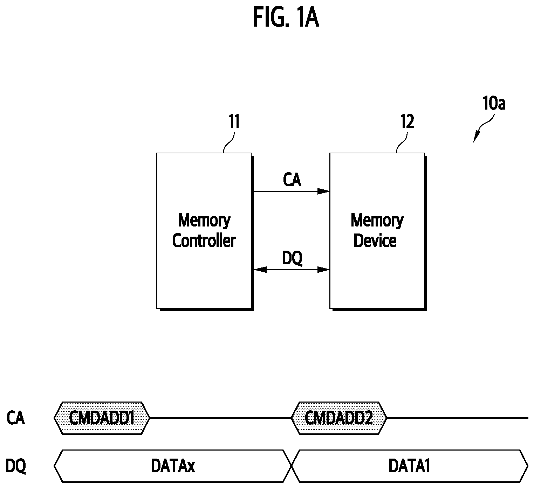

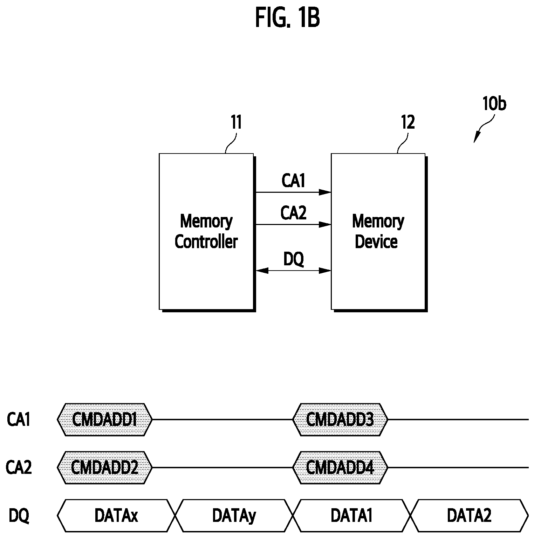

FIGS. 1A and 1B are diagrams illustrating examples of a storage device according to example embodiments of the present disclosure. For example, FIG. 1A illustrates a storage device 10a and an example of an operation of the storage device 10a, in which a command-address is transmitted through a single command-address channel. FIG. 1B illustrates a storage device 10b and an example of an operation of the storage device 10b, in which a command-address is transmitted through two command-address channels. Hereinafter, overlapping descriptions regarding FIGS. 1A and 1B will be omitted.

Referring to FIG. 1A, the storage device 10a may store data or provide stored data to a host in response to a request from the host. The storage device 10a may be referred to as a storage system or a memory system. As illustrated in FIG. 1A, the storage device 10a may include a memory controller 11 and a memory device 12. In some example embodiments, the memory controller 11 and the memory device 12 may be manufactured by a semiconductor process and may be included in a single package or included in two packages, respectively.

The memory controller 11 may communicate with the host and the memory device 12 and may control data exchange between the host and the memory device 12. For example, the memory controller 11 may write data to the memory device 12 or read data stored in the memory device 12 according to a request received from the host. For example, as illustrated in FIG. 1A, the memory controller 11 may generate a command-address based on the request and may provide the command-address to the memory device 12 through a command-address channel CA. In addition, the memory controller 11 may exchange data with the memory device 12 through a data channel DQ.

The memory device 12 may operate in response to the command-address received through the command-address channel CA. For example, the memory device 12 may store data received from the memory controller 11 through the data channel DQ in an area defined by an address in response to a write command, and may provide data stored in the area defined by the address to the memory controller 11 through the data channel DQ in response to a read command. In some example embodiments, the memory device 12 may erase the area (for example, a memory block) defined by the address in response to an erase command.

In some example embodiments, the memory device 12 may include volatile memory cells. For example, the memory device 12 may be DRAMs such as double data rate (DDR) synchronous dynamic random access memory (SDRAM), DDR2 SDRAM, DDR3 SDRAM, DDR4 SDRAM, DDR5 SDRAM, DDR6 SDRAM, low power double data rate (LPDDR) SDRAM, LPDDR2 SDRAM, LPDDR3 SDRAM, LPDDR4 SDRAM, LPDDR4X SDRAM, LPDDR5 SDRAM, graphics double data rate (GDDR) synchronous graphics random access memory (SGRAM), GDDR2 SGRAM, GDDR3 SGRAM, GDDR4 SGRAM, GDDR5 SGRAM, and GDDR6 SGRAM. In some example embodiments, the memory device 12 may include a vertical channel transistor (VCT). In some example embodiments, the memory device 12 may be a non-volatile memory device including non-volatile memory cells. For example, high bandwidth (HB) memory and high density (HD) memory may be non-volatile memory devices such as NAND flash memory, NOR flash memory, and resistive random access memory (RRAM). Hereinafter, although flash memory will be mainly described as a non-volatile memory, it should be noted that example embodiments of the present disclosure are not limited thereto.

As illustrated in FIG. 1A, the memory controller 11 may provide a command-address to the memory device 12 through the single command-address channel CA. For example, as illustrated in FIG. 1A, a first command-address CMDADD1 and a second command-address CMDADD2 may be sequentially provided to the memory device 12 through the command-address channel CA. The memory device 12 may receive or provide first data DATA1 from or to the memory controller 11 through the data channel DQ in response to the first command-address CMDADD1. As illustrated in FIG. 1A, data DATAx may be transmitted through the data channel DQ prior to the first data DATA1 in response to a command-address received before the first command-address CMDADD1.

Referring to FIG. 1B, the storage device 10b may include the memory controller 11 and the memory device 12. The memory controller 11 may provide command-addresses to the memory device 12 through two command-address channels, which are a first command-address channel CA1 and a second command-address channel CA2. In addition, the memory controller 11 may exchange data with the memory device 12 through the data channel DQ.

The memory device 12 may operate in response to command-addresses received through the first command-address channel CA1 and the second command-address channel CA2. For example, as illustrated in FIG. 1B, the first command-address CMDADD 1 and the second command-address CMDADD2 may be provided in parallel to the memory device 12 through the first command-address channel CA1 and the second command-address channel CA2. Subsequently, a third command-address CMDADD3 and a fourth command-address CMDADD4 may be provided in parallel to the memory device 12 through the first command-address channel CA1 and the second command-address channel CA2. The memory device 12 may receive or provide the first data DATA1 from or to the memory controller 11 through the data channel DQ in response to the first command-address CMDADD1. In addition, second data DATA2 may be received or provided from or to the memory controller 11 through the data channel DQ in response to the second command-address CMDADD2. As illustrated in FIG. 1B, the data DATAx and data DATAy may be transmitted through the data channel DQ prior to the first data DATA1 in response to command-addresses received before the first command-address CMDADD1 and the second command-address CMDADD2.

In the storage device 10a of FIG. 1A, the memory device 12 may sequentially receive or output data in response to a command-address received through the single command-address channel CA. Accordingly, the host may sequentially read large amounts of data continuously stored in the storage device 10a or sequentially write large amounts of continuous data to the storage device 10a. On the other hand, in the storage device 10b of FIG. 1B, the memory device 12 may receive or output data in response to command-addresses received in parallel through the first command-address channel CA1 and the second command-address channel CA2. Accordingly, the host may efficiently read data scatteredly stored in the storage device 10b or write data to scattered areas of the storage device 10b.

As will be described below with reference to the drawings, the memory device 12 may be set by an external source, for example, the memory controller 11, to one of a plurality of modes. The memory device 12 may provide variable input/output to adjust the number of command/address channels. Accordingly, the memory device 12 may be accessed in various ways due to the dynamically variable modes. For example, the memory device 12 may support both sequential access such as sequential write or read of data and random access such as write or read of scattered data. In addition, the memory device 12 may be set to one of the plurality of modes during a manufacturing process and thus may be used in various ways, such that productivity of the memory device 12 may be enhanced.

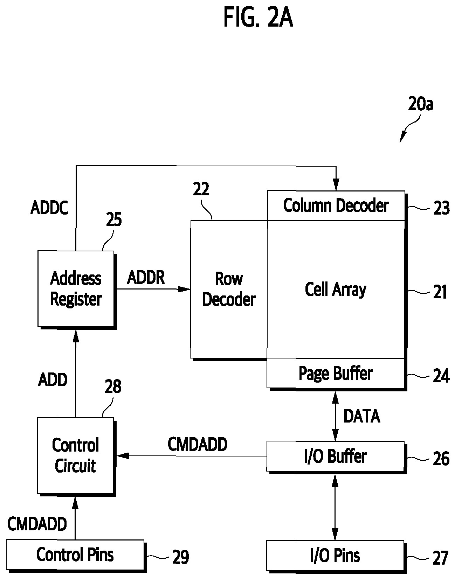

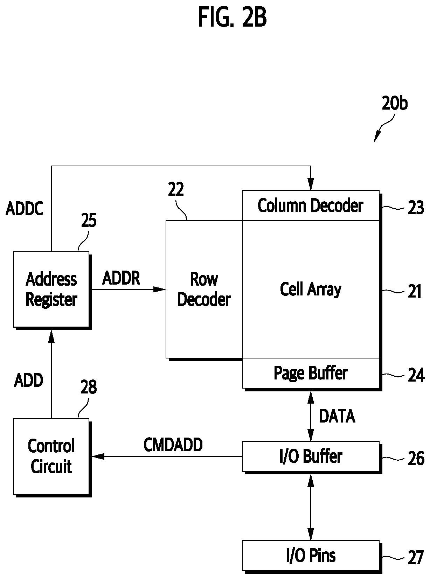

FIGS. 2A and 2B are block diagrams illustrating examples of a memory device according to example embodiments of the present disclosure. For example, FIG. 2A illustrates a memory device 20a including control pins 29 for receiving a command-address, and FIG. 2B illustrates a memory device 20b in which control pins for receiving a command-address are omitted. Hereinafter, overlapping descriptions regarding FIGS. 2A and 2B will be omitted.

Referring to FIG. 2A, the memory device 20a may include a cell array 21, a row decoder 22, a column decoder 23, a page buffer 24, an address register 25, an input/output (I/O) buffer 26, input/output pins 27, a control circuit 28, and control pins 29. The cell array 21 may include a plurality of memory cells. For example, in a flash memory, a memory cell may include a transistor having a floating gate and may store data corresponding to a threshold voltage of the transistor. In some example embodiments, the memory cell may be a single level cell (SLC) storing one bit. In some example embodiments, the memory cell may be a multi-level cell (MLC) storing two bits or a triple level cell (TLC) storing three bits. The cell array 21 may include a plurality of blocks, and one block may include memory cells connected to a plurality of word lines. In some example embodiments, read and write operations may be performed in page units while an erase operation may be performed in block units. When a memory cell stores a single bit, memory cells connected to an identical word line may store one page. When each memory cell stores two or more bits, memory cells connected to an identical word line may store two or more pages.

The row decoder 22 may be connected to the cell array 21 through the plurality of word lines. The row decoder 22 may activate one of the plurality of word lines according to a row address ADDR. Accordingly, memory cells connected to the activated word line in the cell array 21 may be selected. The column decoder 23 may select a portion of the memory cells (or bit lines) selected by the row address ADDR according to a column address ADDC. The page buffer 24 may store data to be programmed into the cell array 21 or data read from the cell array 21. For example, the page buffer 24 may store data DATA received from the input/output buffer 26 during a write operation and may store data DATA read from the cell array 21 during a read operation.

The address register 25 may obtain an address ADD received from outside the memory device 20a, for example, from the memory controller, through the control circuit 28 and may store the address ADD. In some example embodiments, the address register 25 may extract the row address ADDR and the column address ADDC from the address ADD. As illustrated in FIG. 2A, the address register 25 may provide the row address ADDR to the row decoder 22 and may provide the column address ADDC to the column decoder 23.

The input/output buffer 26 may be connected to the input/output pins 27. The input/output buffer 26 may store data DATA received through the input/output pins 27 and may provide the stored data DATA to the page buffer 24. In addition, the input/output buffer 26 may store data received from the page buffer 24 and may output the stored data DATA through the input/output pins 27.

In some example embodiments, the input/output buffer 26 may receive a command-address CMDADD through at least one of the input/output pins 27. For example, the input/output buffer 26 may receive or output data DATA through the input/output pins 27 in a first mode and may receive the command-address CMDADD through at least one of the input/output pins 27 in a second mode. The input/output buffer 26 may provide the command-address CMDADD in the second mode to the control circuit 28. In the present disclosure, the first mode may be referred to as a sequential mode and the second mode may be referred to as a random mode.

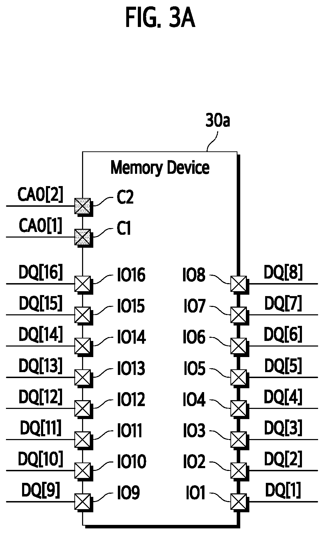

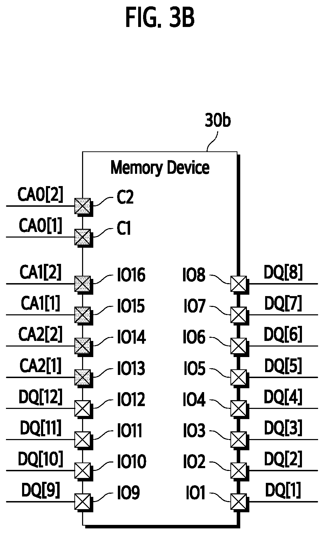

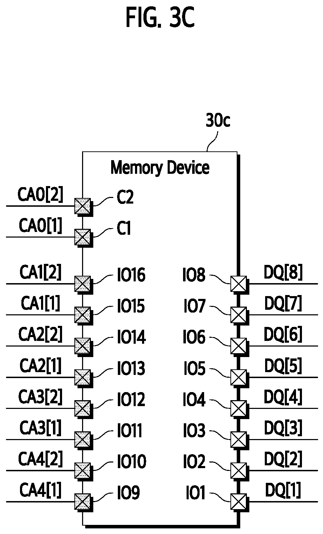

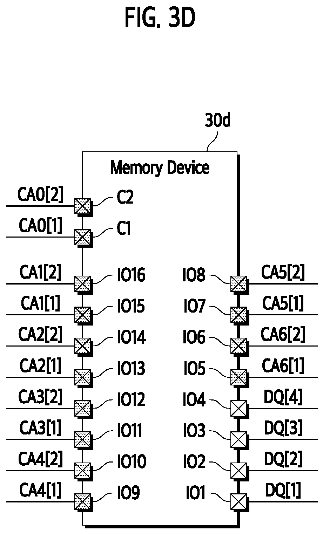

The input/output pins 27 may be exposed to the outside of the memory device 20a, may be electrically connected to pins of the memory controller or another memory device through a wire or a bump, and may be referred to as input/output pads. In some example embodiments, as will be described below with reference to FIGS. 3A, 3B, 3C, and 3D, at least one of the input/output pins 27 may be used to receive or output data or to receive a command-address depending on a mode. For example, the input/output pins 27 may include at least one first pin configured to receive or output at least one bit of the data DATA in the first mode and receive at least one bit of the command-address CMDADD in the second mode. Accordingly, the memory device 20a may have variable input/output depending on the mode.

The control circuit 28 may control components of the memory device 20a based on the command-address CMDADD received by the memory device 20a. For example, the control circuit 28 may identify a command by decoding the command and may generate control signals for controlling the components according to the identified command. In addition, the control circuit 28 may provide the address ADD to the address register 25. In addition, the control circuit 28 may identify a mode and may control the components according to the mode.

In some example embodiments, the control circuit 28 may control the components based on one command-address CMDADD in the first mode and may control the components based on two or more command-addresses CMDADD in the second mode. For example, the control circuit 28 may receive the command-address CMDADD through the control pins 29 in the first mode and may receive the two or more command-addresses CMDADD from the input/output buffer 26 in the second mode. In some example embodiments, the control circuit 28 may control the components based on the command-address CMDADD received from the input/output buffer 26 in the second mode as well as the command-address CMDADD received from the control pins 29. Accordingly, the memory device 20a may sequentially write or read continuous data as described above with reference to FIG. 1A in the first mode and may write or read scattered data as described above with reference to FIG. 1B in the second mode.

Referring to FIG. 2B, the memory device 20b may include the cell array 21, the row decoder 22, the column decoder 23, the page buffer 24, the address register 25, the input/output buffer 26, the input/output pins 27, and the control circuit 28. Compared to the memory device 20a of FIG. 2A, the control pins may be omitted in the memory device 20b.

In the first mode, the input/output buffer 26 may receive the command-address CMDADD through at least one of the input/output pins 27 during a first period and may receive or output data DATA through the input/output pins 27 during a second period. In the second mode, the input/output buffer 26 may receive two or more command-addresses CMDADD in parallel through at least a portion of the input/output pins 27. Accordingly, the control circuit 28 may receive the command-address CMDADD from the input/output buffer 26 in the first mode and may receive the two or more command-addresses CMDADD from the input/output buffer 26 in the second mode.

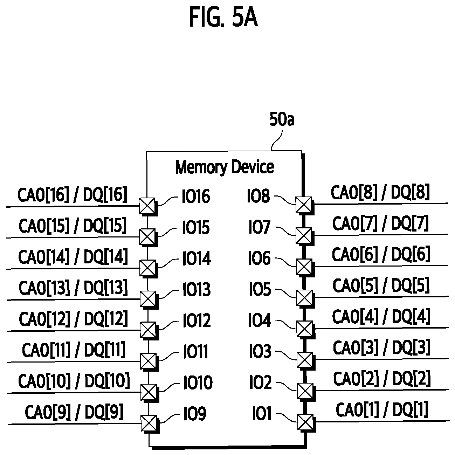

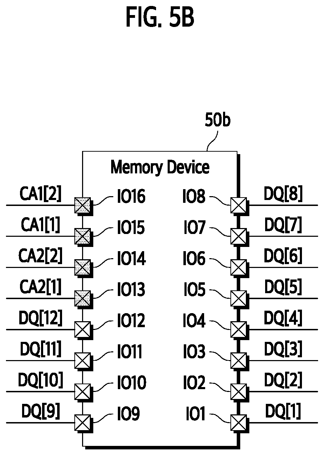

A structure including dedicated pins for receiving a command-address, such as the memory device 20a of FIG. 2A, may be referred to as a separate command address (SCA) structure, and a structure in which the dedicated pins for receiving a command-address are omitted, such as the memory device 20b of FIG. 2B, may be referred to as a non-SCA structure. Examples of the SCA structure will be described below with reference to FIGS. 3A, 3B, 3C, and 3D, and examples of the non-SCA structure will be described below with reference to FIGS. 5A and 5B.

FIGS. 3A, 3B, 3C, and 3D are diagrams illustrating examples of a memory device according to example embodiments of the present disclosure. For example, FIGS. 3A, 3B, 3C, and 3D illustrate memory devices 30a, 30b, 30c, and 30d, respectively, having the SCA structure and set to a first mode to a fourth mode, respectively. In some example embodiments, the memory device may support only two or three of the first mode to the fourth mode. In some example embodiments, the memory device may include a different number of control pins and/or input/output pins from those illustrated in FIGS. 3A, 3B, 3C, and 3D. In FIGS. 3A, 3B, 3C, and 3D, the memory devices 30a, 30b, 30c, and 30d are assumed to include the components of the memory device 20a of FIG. 2A. FIGS. 3A, 3B, 3C, and 3D are described with reference to FIG. 2A, and overlapping descriptions in FIGS. 3A, 3B, 3C, and 3D will be omitted.

Referring to FIG. 3A, the memory device 30a may include a first control pin C1, a second control pin C2, and a first input/output pin IO1 to a sixteenth input/output pin IO16. In the first mode, the memory device 30a may receive a command-address through the control pins and may receive or output data through the input/output pins. For example, as illustrated in FIG. 3A, the first control pin C1 and the second control pin C2 may be used for a 2-bit command-address channel CA0 [1:2]. In addition, the first input/output pin IO1 to the sixteenth the input/output pin IO16 may be used for a 16-bit data channel DQ [1:16]. Accordingly, as described above with reference to FIG. 1A, the memory device 30a may receive or output data through the data channel DQ [1:16] in response to the command-address received through the command-address channel CA0 [1:2].

Referring to FIG. 3B, the memory device 30b may include the first control pin C1, the second control pin C2, and the first input/output pin IO1 to the sixteenth input/output pin IO16. In the second mode, the memory device 30b may receive a command-address through at least one input/output pin as well as through the control pins and may receive or output data through the remaining input/output pins. For example, as illustrated in FIG. 3B, the first control pin C1 and the second control pin C2 may be used for the 2-bit command-address channel CA0 [1:2]. In addition, the fifteenth input/output pin IO15 and the sixteenth input/output pin IO16 may be used for a 2-bit first command-address channel CA1 [1:2], and the thirteenth input/output pin IO13 and the fourteenth input/output pin IO14 may be used for a 2-bit second command-address channel CA2 [1:2]. The remaining input/output pins, which are the first input/output pin IO1 to the twelfth input/output pin 1012, may be used for a data channel DQ [1:12].

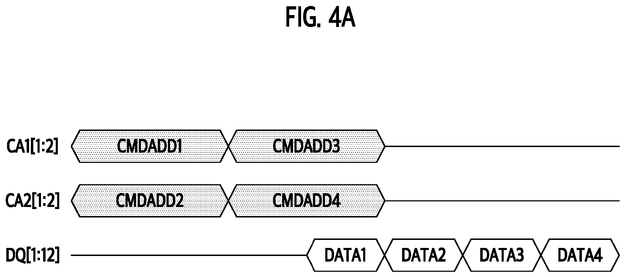

Compared to the memory device 30a of FIG. 3A, in the memory device 30b, the thirteenth input/output pin IO13 to the sixteenth input/output pin IO16 may be used for command-address channels instead of a data channel. Accordingly, the memory device 30b may receive three command-addresses in parallel in the second mode. In some example embodiments, as will be described below with reference to FIG. 4A, the command-address channel CA0 [1:2] may not be used in the second mode, and the memory device 30b may receive two command-addresses in parallel.

Referring to FIG. 3C, the memory device 30c may include the first control pin C1, the second control pin C2, and the first input/output pin IO1 to the sixteenth input/output pin IO16. In the third mode, the memory device 30c may receive a command-address through at least one input/output pin as well as through the control pins and may receive or output data through the remaining input/output pins. For example, as illustrated in FIG. 3C, the first control pin C1 and the second control pin C2 may be used for the 2-bit command-address channel CA0 [1:2]. The fifteenth input/output pin 1015 and the sixteenth input/output pin IO16 may be used for the 2-bit first command-address channel CA1 [1:2], and the thirteenth input/output pin 1013 and the fourteenth input/output pin IO14 may be used for the 2-bit second command-address channel CA2 [1:2]. In addition, the eleventh input/output pin IO11 and the twelfth input/output pin IO12 may be used for a 2-bit third command-address channel CA3 [1:2], and the ninth input/output pin IO9 and the tenth input/output pin IO10 may be used for a fourth command-address channel CA4 [1:2]. The remaining input/output pins, which are the first input/output pin IO1 to the eighth input/output pins IO8, may be used for a data channel DQ [1:8].

Compared to the memory device 30a of FIG. 3A, in the memory device 30c, the ninth input/output pin IO9 to the sixteenth input/output pin IO16 may be used for command-address channels instead of a data channel. Accordingly, the memory device 30c may receive five command-addresses in parallel in the third mode. In some example embodiments, as will be described below with reference to FIG. 4A, the command-address channel CA0 [1:2] may not be used in the third mode, and the memory device 30c may receive four command-addresses in parallel.

Referring to FIG. 3D, the memory device 30d may include the first control pin C1, the second control pin C2, and the first input/output pin IO1 to the sixteenth input/output pin IO16. In the fourth mode, the memory device 30d may receive a command-address through at least one input/output pin as well as through the control pins and may receive or output data through the remaining input/output pins. For example, as illustrated in FIG. 3D, the first control pin C1 and the second control pin C2 may be used for the 2-bit command-address channel CA0 [1:2]. The fifteenth input/output pin IO15 and the sixteenth input/output pin IO16 may be used for the 2-bit first command-address channel CA1 [1:2], and the thirteenth input/output pin 1013 and the fourteenth input/output pin IO14 may be used for the 2-bit second command-address channel CA2 [1:2]. The eleventh input/output pin IO11 and the twelfth input/output pin IO12 may be used for the 2-bit third command-address channel CA3 [1:2], and the ninth input/output pin IO9 and the tenth input/output pin IO10 may be used for the fourth command-address channel CA4 [1:2]. In addition, the seventh input/output pin IO7 and the eighth input/output pin IO8 may be used for a fifth command-address channel CA5 [1:2], and the fifth input/output pin IO5 and the sixth input/output pin IO6 may be used for a sixth command-address channel CA6 [1:2]. The remaining input/output pins, which are the first input/output pin IO1 to the fourth input/output pin IO4, may be used for a data channel DQ [1:4].

Compared to the memory device 30a of FIG. 3A, in the memory device 30d, the fifth input/output pin IO5 to the sixteenth input/output pin IO16 may be used for command-address channels instead of a data channel. Accordingly, the memory device 30d may receive seven command-addresses in parallel in the fourth mode. In some example embodiments, as will be described below with reference to FIG. 4A, the command-address channel CA0 [1:2] may not be used in the fourth mode, and the memory device 30d may receive six command-addresses in parallel.

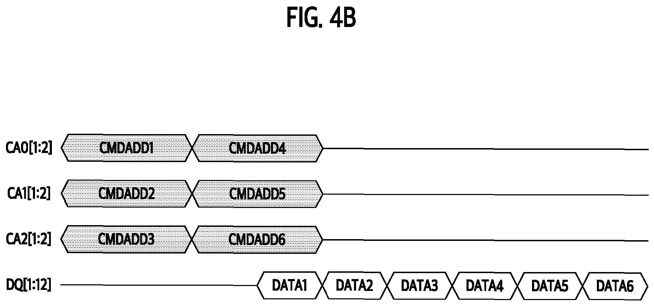

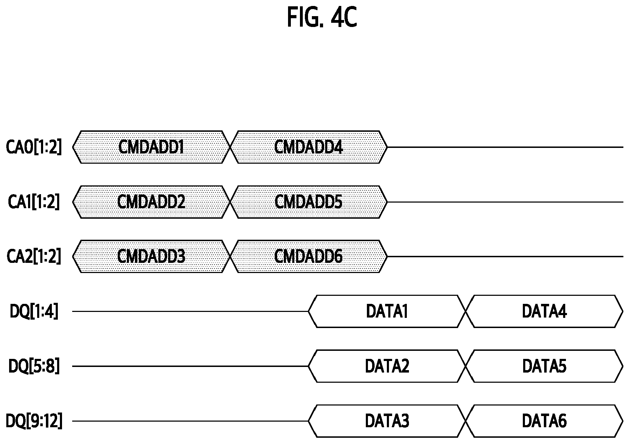

FIGS. 4A, 4B, and 4C are timing diagrams illustrating examples of operations of a memory device according to example embodiments of the present disclosure. For example, the timing diagrams of FIGS. 4A, 4B, and 4C illustrate examples of operations of the memory device 30b of FIG. 3B set to the second mode. Hereinafter, FIGS. 4A, 4B, and 4C are described with reference to FIG. 3B, and overlapping descriptions in FIGS. 4A, 4B, and 4C will be omitted.

Referring to FIG. 4A, in some example embodiments, the command-address channel CA0 [1:2] may not be used in the second mode. For example, as illustrated in FIG. 4A, the memory device 30b may receive the first command-address CMDADD1 and the second command-address CMDADD2 in parallel through the first command-address channel CA1 [1:2] and the second command-address channel CA2 [1:2]. Subsequently, the memory device 30b may receive the third command-address CMDADD3 and the fourth command-address CMDADD4 in parallel through the first command-address channel CA1 [1:2] and the second command-address channel CA2 [1:2]. Accordingly, the memory device 30b may receive or output the first data DATA1 to fourth data DATA4 corresponding to the first command-address CMDADD1 to the fourth command-address CMDADD4, respectively, through the data channel DQ [1:12].

Referring to FIG. 4B, in some example embodiments, the command-address channel CA0 [1:2] may be used in the second mode. For example, as illustrated in FIG. 4B, the memory device 30b may receive the first command-address CMDADD1 to the third command-address CMDADD3 in parallel through the command-address channel CA0 [1:2], the first command-address channel CA1 [1:2], and the second command-address channel CA2 [1:2]. Subsequently, the memory device 30b may receive the fourth command-address CMDADD4 to a sixth command-address CMDADD6 in parallel through the command-address channel CA0 [1:2], the first command-address channel CA1 [1:2], and the second command-address channel CA2 [1:2]. Accordingly, the memory device 30b may receive or output the first data DATA1 to sixth data DATA6 corresponding to the first command-address CMDADD1 to the sixth command-address CMDADD6, respectively, through the data channel DQ [1:12].

Referring to FIG. 4C, in some example embodiments, command-address channels may be each mapped to portions of a data channel. For example, as illustrated in FIG. 4C, the command-address channel CA0 [1:2] may be mapped to a first bit to a fourth bit DQ [1:4] of the data channel, the first command-address channel CA1 [1:2] may be mapped to a fifth bit to an eighth bit DQ [5:8] of the data channel, and the second command-address channel CA2 [1:2] may be mapped to a ninth bit to a twelfth bit DQ [9:12] of the data channel.

The memory device 30b may receive the first command-address CMDADD1 to the third command-address CMDADD3 in parallel through the command-address channel CA0 [1:2], the first command-address channel CA1 [1:2], and the second command-address channel CA2 [1:2]. Subsequently, the memory device 30b may receive the fourth command-address CMDADD4 to the sixth command-address CMDADD6 in parallel through the command-address channel CA0 [1:2], the first command-address channel CA1 [1:2], and the second command-address channel CA2 [1:2]. Accordingly, the memory device 30b may receive or output the first data DATA1 corresponding to the first command-address CMDADD1 through the first bit to the fourth bit DQ [1:4] of the data channel, may receive or output the second data DATA2 corresponding to the second command-address CMDADD2 through the fifth bit to the eighth bit DQ [5:8] of the data channel, and may receive or output third data DATA3 corresponding to the third command-address CMDADD3 through the ninth bit to the twelfth bit DQ[9:12] of the data channel.

FIGS. 5A and 5B are diagrams illustrating examples of a memory device according to example embodiments of the present disclosure. For example, FIGS. 5A and 5B illustrate memory devices 50a and 50b, respectively, having a non-SCA structure and set to the first mode and the second mode, respectively. In some example embodiments, the memory device may support an additional mode providing more command-address channels in addition to the first mode and the second mode. In some example embodiments, the memory device may include a different number of control pins and/or input/output pins from those illustrated in FIGS. 5A and 5B. In FIGS. 5A and 5B, the memory devices 50a and 50b are assumed to include the components of the memory device 20b of FIG. 2B. FIGS. 5A and 5B are described with reference to FIG. 2B, and overlapping descriptions in FIGS. 5A and 5B will be omitted.

Referring to FIG. 5A, the memory device 50a may include the first input/output pin IO1 to the sixteenth input/output pin 1016. In the first mode, the memory device 50a may receive a command-address and may receive or output data through the first input/output pin IO1 to the sixteenth input/output pin IO16. For example, as illustrated in FIG. 5A, the first input/output pin IO1 to the sixteenth input/output pin IO16 may be used for a 16-bit command-address channel CA0 [1:16]. In addition, the first input/output pin IO1 to the sixteenth input/output pin IO16 may be used for the 16-bit data channel DQ [1:16]. To this end, the memory device 50a may receive or output data at a time different from a time at which the command-address is received. In some example embodiments, only a portion of the input/output pins may be used to receive the command-address in the first mode. For example, the ninth input/output pin IO9 to the sixteenth input/output pin IO16 among the first input/output pin IO1 to the sixteenth input/output pin IO16 may be used for an 8-bit command-address channel CA0 [9:16].

Referring to FIG. 5B, the memory device 50b may include the first input/output pin IO1 to the sixteenth input/output pin IO16. In the second mode, the memory device 50b may receive a command-address through a portion of the first input/output pin IO1 to the sixteenth input/output pin IO16 and may receive or output data through the remaining input/output pins of the first input/output pin IO1 to the sixteenth input/output pin IO16. For example, as illustrated in FIG. 5B, the fifteenth input/output pin IO15 and the sixteenth input/output pin IO16 may be used for the 2-bit first command-address channel CA1 [1:2], and the thirteenth input/output pin 1013 and the fourteenth input/output pin IO14 may be used for the 2-bit second command-address channel CA2 [1:2]. The first input/output pin IO1 to the twelfth input/output pin 1012 may be used for the 12-bit data channel DQ [1:12]. Accordingly, command-addresses may be received in parallel with data being received or output.

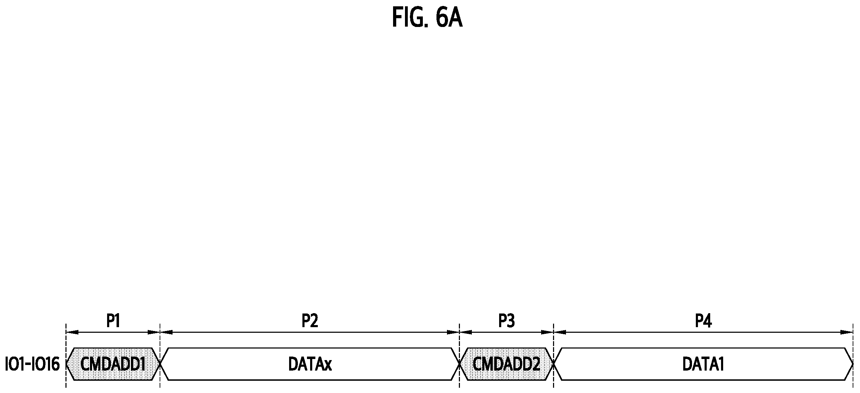

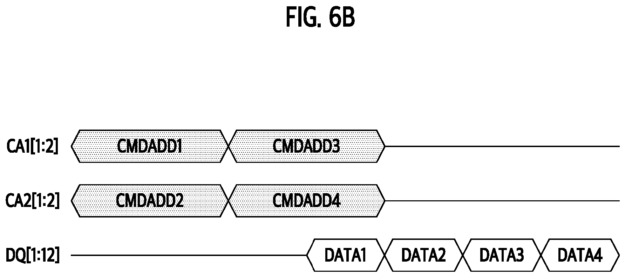

FIGS. 6A and 6B are timing diagrams illustrating examples of operations of a memory device according to example embodiments of the present disclosure. For example, the timing diagram of FIG. 6A illustrates an example of an operation of the memory device 50a of FIG. 5A set to the first mode, and the timing diagram of FIG. 6B illustrates an example of an operation of the memory device 50b of FIG. 5B set to the second mode. Hereinafter, FIGS. 6A and 6B will be described with reference to FIGS. 5A and 5B.

Referring to FIG. 6A, in the first mode, through the first input/output pin IO1 to the sixteenth input/output pin IO16, the memory device 50a may receive a command-address and may receive or input and output data. As illustrated in FIG. 6A, during a first period P1, the memory device 50a may receive the first command-address CMDADD1 through the first input/output pin IO1 to the sixteenth input/output pin IO16. Subsequently, during a second period P2, the memory device 50a may receive or output the data DATAx corresponding to the command-address received before the first command-address CMDADD1 through the first input/output pin IO1 to the sixteenth input/output pin IO16.

During a third period P3, the memory device 50a may receive the second command-address CMDADD2 through the first input/output pin IO1 to the sixteenth input/output pin IO16. Subsequently, during a fourth period P4, the memory device 50a may receive or output the first data DATA1 corresponding to the first command-address CMDADD1 received during the first period P1 through the first input/output pin IO1 to the sixteenth input/output pin IO16.

Referring to FIG. 6B, in the second mode, the memory device 50b may receive command-addresses through the 2-bit first command-address channel CA1 [1:2] and the 2-bit second command-address channel CA2 [1:2] and may receive or output data through the 12-bit data channel DQ [1:12]. As illustrated in FIG. 6B, the memory device 50b may receive the first command-address CMDADD1 and the second command-address CMDADD2 in parallel through the 2-bit first command-address channel CA1 [1:2] and the 2-bit second command-address channel CA2 [1:2]. Subsequently, the memory device 50b may receive the third command-address CMDADD3 and the fourth command-address CMDADD4 in parallel through the 2-bit first command-address channel CA1 [1:2] and the 2-bit second command-address channel CA2 [1:2]. Accordingly, the memory device 50b may receive or output the first data DATA1 to the fourth data DATA4 corresponding to the first command-address CMDADD1 to the fourth command-address CMDADD4, respectively, through the 12-bit data channel DQ [1:12].

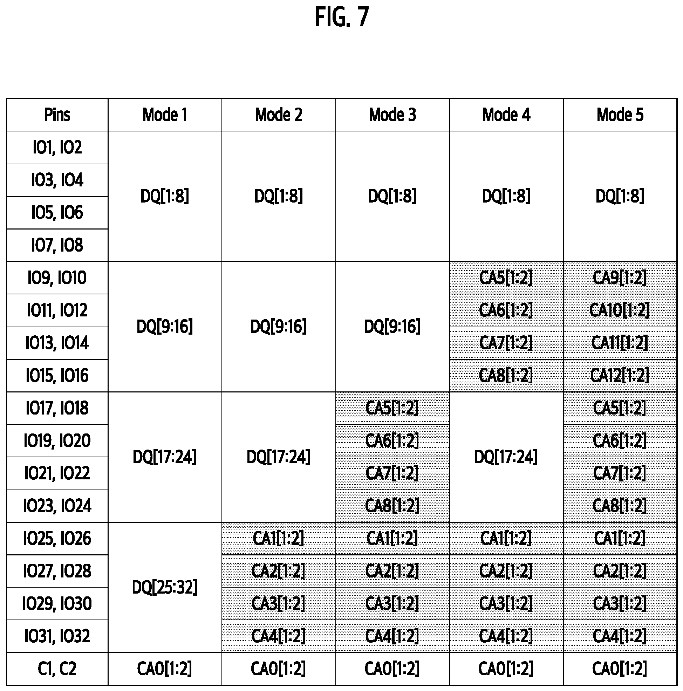

FIG. 7 illustrates a table showing modes of a memory device according to example embodiments of the present disclosure. In FIG. 7, the memory device may include the first control pin C1, the second control pin C2, and the first input/output pin IO1 to a thirty-second input/output pin IO32.

Referring to FIG. 7, in a first mode, the first control pin C1 and the second control pin C2 may be used for a command-address channel CA0, and the first input/output pin IO1 to the thirty-second input/output pin IO32 may be used for a 32-bit data channel DQ [1:32].

In a second mode, the twenty-fifth input/output pin IO25 to the thirty-second input/output pin IO32 may be used for a first command-address channel CA1 to a fourth command-address channel CA4, and the first input/output pin IO1 to the twenty-fourth input/output pin IO24 may be used for a 24-bit data channel DQ [1:24]. In some example embodiments, the command-address channel CA0 may not be used in the second mode.

In a third mode, the seventeenth input/output pin IO17 to the thirty-second input/output pin IO32 may be used for the first command-address channel CA1 to an eighth command-address channel CA8, and the first input/output pin IO1 to the sixteenth input/output pin IO16 may be used for a 16-bit data channel DQ [1:16]. In some example embodiments, the command-address channel CA0 may not be used in the third mode.

In a fourth mode, the twenty-fifth input/output pin IO25 to the thirty-second input/output pin IO32 may be used for the first command-address channel CA1 to the fourth command-address channel CA4, and the ninth input/output pin IO9 to the sixteenth input/output pin IO16 may be used for the fifth command-address channel CA5 to the eighth command-address channel CA8. In some example embodiments, the command-address channel CA0 may not be used in the fourth mode.

In a fifth mode, the ninth input/output pin IO9 to the thirty-second input/output pin IO32 may be used for the first command-address channel CA1 to a twelfth command-address channel CA12, and the first input/output pin IO1 to the eighth input/output pin IO8 may be used for an 8-bit data channel DQ [1:8]. In some example embodiments, the command-address channel CA0 may not be used in the fifth mode.

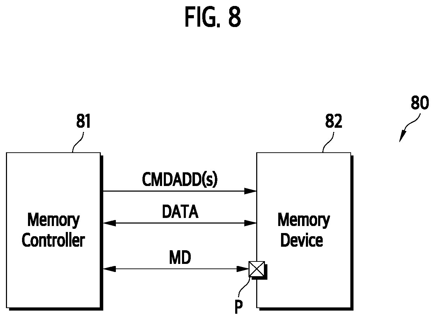

FIG. 8 is a block diagram illustrating a storage device 80 according to example embodiments of the present disclosure. As illustrated in FIG. 8, the storage device 80 may include a memory controller 81 and a memory device 82. As described above with reference to the drawings, the memory controller 81 may provide at least one command-address CMDADD to the memory device 82 according to a mode and may exchange the data DATA with the memory device 82.

In some example embodiments, the memory device 82 may identify a mode based on a mode signal received through at least one pin P. As illustrated in FIG. 8, the memory device 82 may include the at least one pin P and may receive a mode signal MD from the memory controller 81 through the at least one pin P. For example, when the memory device 82 receives the mode signal MD through two pins, a 2-bit mode signal MD may indicate one of four modes. When the memory device 82 receives the mode signal MD through four pins, a 4-bit mode signal MD may indicate one of sixteen modes. A control circuit included in the memory device 82 may receive the mode signal MD through the at least one pin P and may identify the mode based on the mode signal MD. In some example embodiments, at least one of the modes that can be indicated by the mode signal MD may be reserved. In some example embodiments, differently from that illustrated in FIG. 8, the at least one pin P may be hardwired to receive a constant signal, and the memory device 82 may operate in one of a plurality of modes.

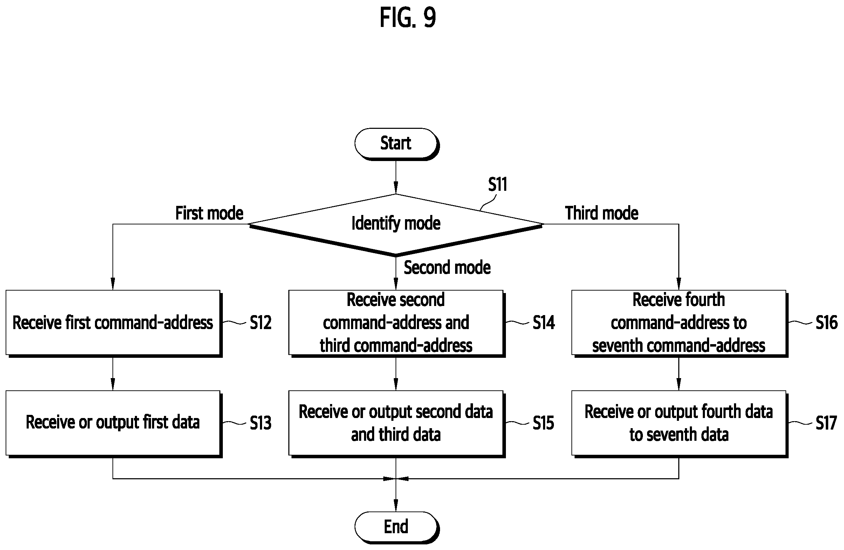

FIG. 9 is a flowchart illustrating a method performed by a memory device according to example embodiments of the present disclosure. As illustrated in FIG. 9, the method may include a plurality of operations S11 to S17. In some example embodiments, the method of FIG. 9 may be performed by the memory device 20a of FIG. 2A or the memory device 20b of FIG. 2B. Hereinafter, FIG. 9 is described with reference to FIG. 2A.

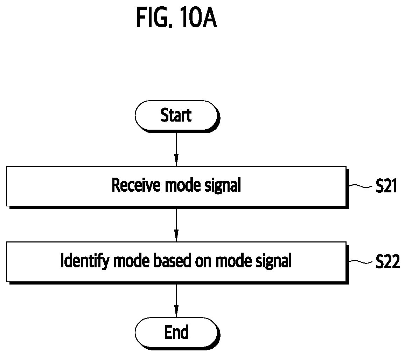

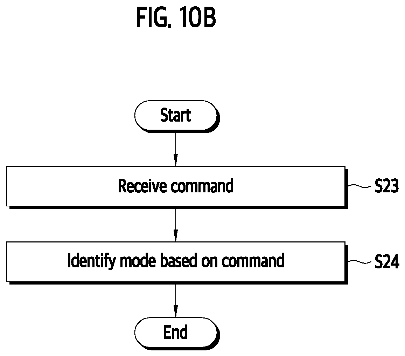

Referring to FIG. 9, in operation S11, a mode may be identified. For example, the control circuit 28 may identify a mode and may control components of the memory device 20a according to the identified mode. Examples of operation S11 will be described below with reference to FIGS. 10A and 10B. As illustrated in FIG. 9, when a first mode is identified, operation S12 and operation S13 may be subsequently performed. When a second mode is identified, operation S14 and operation S15 may be subsequently performed. When a third mode is identified, operation S16 and operation S17 may be subsequently performed. In some example embodiments, the memory device 20a may support only the first mode and the second mode and may further support at least one additional mode.

When the first mode is identified, in operation S12, a first command-address may be received. For example, the control circuit 28 may receive the first command-address through the control pins 29. The control circuit 28 may decode a command based on the first command-address and may provide the address ADD to the address register 25. In the case of the memory device 20b of FIG. 2B, the first command-address may be received through at least one first input/output pin through which first data described below is received or output and may be received during a period different from a period during which the first data is received or output.

In operation S13, the first data may be received or output. For example, the control circuit 28 may control components of the memory device 20a based on the command decoded in operation S12, and accordingly, the input/output buffer 26 may receive or output the first data through the input/output pins 27. The input/output buffer 26 may receive or output at least one bit of the first data through the at least one first input/output pin and may receive or output at least a portion of the first data through a plurality of second input/output pins.

When the second mode is identified, in operation S14, a second command-address and a third command-address may be received. For example, the control circuit 28 may receive the second command-address and the third command-address in parallel through at least one of the control pins 29 and the input/output pins 16 or through at least one of the input/output pins 16. In some example embodiments, the input/output buffer 26 may receive at least one bit of the third command-address through the at least one first input/output pin through which at least one bit of the first data is received or output in operation S13.

In operation S15, second data and third data may be received or output. For example, the control circuit 28 may control the input/output buffer 26 to receive or output the second data based on the second command-address received in operation S14 and may control the input/output buffer 26 to receive or output the third data based on the third command-address received in operation S14. In some example embodiments, as described above with reference to FIGS. 4A and 4B, the input/output buffer 26 may sequentially receive or output the second data and the third data through the plurality of second input/output pins through which at least a portion of the first data is received or output in operation S13. In some example embodiments, as described above with reference to FIG. 4C, the input/output buffer 26 may receive or output the second data through at least one of the plurality of second input/output pins through which at least a portion of the first data is received or output in operation S13 and may receive or output the third data through at least another one of the plurality of second input/output pins.

When the third mode is identified, in operation S16, a fourth command-address to a seventh command-address may be received. For example, the control circuit 28 may receive the fourth command-address to the seventh command-address in parallel through at least one of the control pins 29 and the input/output pins 16 or through at least one of the input/output pins 16. To this end, the input/output buffer 26 may receive at least one bit of the seventh command-address through at least one of the plurality of second input/output pins through which at least a portion of the first data is received or output in operation S13.

In operation S17, fourth data to seventh data may be received or output. For example, the control circuit 28 may control the input/output buffer 26 to receive or output the fourth data to the seventh data based on the fourth command-address to the seventh command-address received in operation S16.

FIGS. 10A and 10B are flowcharts illustrating examples of a method performed in a memory device according to example embodiments of the present disclosure. For example, FIGS. 10A and 10B illustrate examples of operation S11 of FIG. 9. In some example embodiments, the method of FIGS. 10A and 10B may be performed by the control circuit 28 of FIG. 2A. Hereinafter, FIGS. 10A and 10B are described with reference to FIG. 2A.

Referring to FIG. 10A, in operation S21, a mode signal may be received. For example, as described above with reference to FIG. 8, the memory device 20a may include at least one pin receiving a mode signal. The control circuit 28 may receive the mode signal through the at least one pin. In some example embodiments, the mode signal may be a multi-bit signal and may indicate one of a plurality of modes according to a value.

In operation S22, a mode may be identified based on the mode signal. For example, the control circuit 28 may identify one of a plurality of modes based on a value of the mode signal received in operation S21. In some example embodiments, at least one of the plurality of modes may be reserved, and when the reserved mode is identified, the control circuit 28 may identify a predefined default mode.

Referring to FIG. 10B, in operation S23, a command may be received. For example, the control circuit 28 may receive the command indicating one of the plurality of modes. In operation S24, a mode may be identified based on the command. For example, the control circuit 28 may identify one of the plurality of modes by decoding the command.

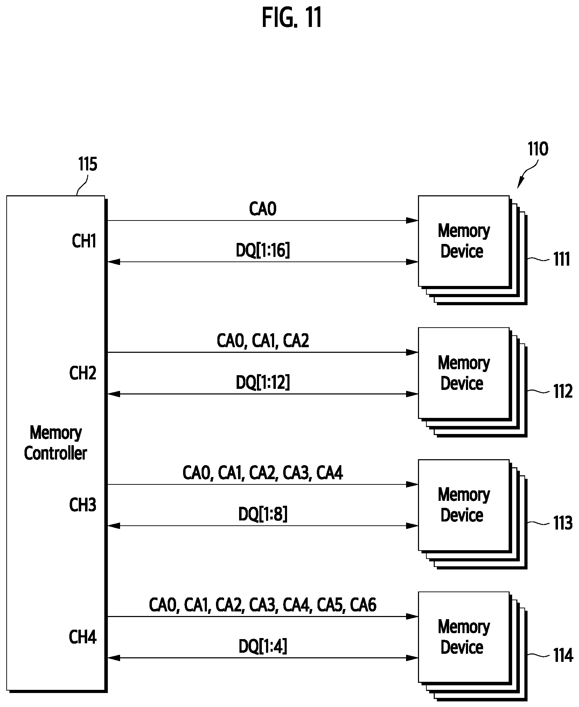

FIG. 11 is a block diagram illustrating a storage device 110 according to example embodiments of the present disclosure. As illustrated in FIG. 11, the storage device 110 may include a first memory device 111 to a fourth memory device 114 and a memory controller 115. Each of the first memory device 111 to the fourth memory device 114 may correspond to the memory device described above with reference to the drawings. In some example embodiments, the storage device 110 may include a different number of memory devices from those illustrated in FIG. 11.

The memory controller 115 may communicate with the first memory device 111 to the fourth memory device 114 through a first channel CH1 to a fourth channel CH4. In example embodiments, the first channel CH1 to the fourth channel CH4 may have different configurations. For example, as illustrated in FIG. 11, the first channel CH1 may include a command-address channel CA0 and the 16-bit data channel DQ [1:16], and the second channel CH2 may include the command-address channel CA0, a first command-address channel CA1, a second command-address channel CA2, and the 12-bit data channel DQ [1:12]. In addition, the third channel CH3 may include the command-address channel CA0, the first command-address channel CA1 to a fourth command-address channel CA4, and an 8-bit data channel DQ [1:8], and the fourth channel CH4 may include the command-address channel CA0, the first command-address channel CA1 to a sixth command-address channel CA6, and a 4-bit data channel DQ [1:4]. As described above with reference to the drawings, the first memory device 111 to the fourth memory device 114 may be set to different modes despite having an identical structure. Accordingly, channels having different configurations may be used in the storage device 110.

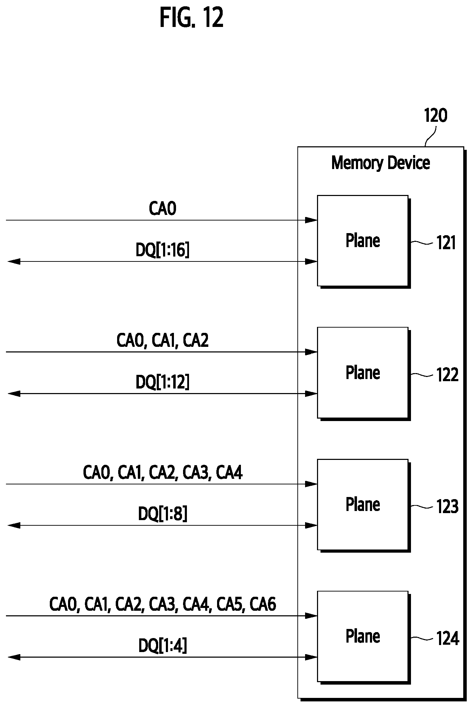

FIG. 12 is a block diagram illustrating a memory device 120 according to example embodiments of the present disclosure. As illustrated in FIG. 12, the memory device 120 may include a first plane 121 to a fourth plane 124. In some example embodiments, the memory device 120 may include a different number of planes from those illustrated in FIG. 12.

A plane may be a unit in which data is independently written or read and may be referred to as a mat. For example, a plane may include a cell array, a row decoder, a column decoder, and a page buffer and may independently write data to or read data from the cell array with respect to another plane. As illustrated in FIG. 12, when the memory device 120 includes the first plane 121 to the fourth plane 124, the first plane 121 to the fourth plane 124 may independently perform a data write or read operation.

In some example embodiments, a mode may be set for each plane. For example, the first plane 121 to the fourth plane 124 may be set to different modes. As illustrated in FIG. 12, the first plane 121 may support the command-address channel CA0 and the 16-bit data channel DQ [1:16], and the second plane 122 may support the command-address channel CA0, the first command-address channel CA1, the second command-address channel CA2, and the 12-bit data channel DQ [1:12]. In addition, the third plane 123 may support the command-address channel CA0, the first command-address channel CA1 to the fourth command-address channel CA4, and the 8-bit data channel DQ [1:8], and the fourth plane 124 may support the command-address channel CA0, the first command-address channel CA1 to the sixth command-address channel CA6, and the 4-bit data channel DQ [1:4].

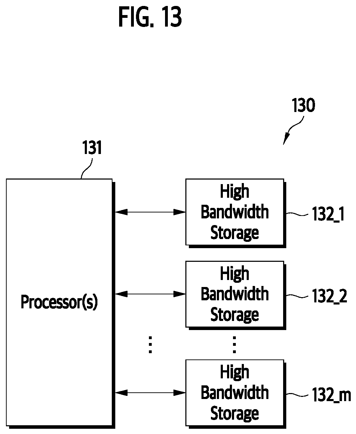

FIG. 13 is a block diagram illustrating a system 130 according to example embodiments of the present disclosure. As illustrated in FIG. 13, the system 130 may include a processor 131 and a first high bandwidth storage 132_1 to an m^{th} high bandwidth storage 132_m. In some example embodiments, the system 130 may correspond to a single package, and the processor 131 and the first high bandwidth storage 132_1 to the m^{th} high bandwidth storage 132_m may be mounted on an interposer in the single package. In some example embodiments, the system 130 may correspond to a module, and packages including the processor 131 and each of the first high bandwidth storage 132_1 to the m^{th} high bandwidth storage 132_m may be mounted on a board. When a high bandwidth storage includes a flash memory, the high bandwidth storage may be referred to as high bandwidth flash (HBF).

The processor 131 may be any component that processes data. For example, the processor 131 may be a processor that executes software code, a fixed intellectual property (IP) such as a hardware accelerator, or a reconfigurable component such as a field programmable gate array (FPGA). In addition, the processor 131 may be a component designed for parallel processing, such as a graphic processing unit (GPU) or a neural processing unit (NPU).

The processor 131 may access the first high bandwidth storage 132_1 to the m^{th} high bandwidth storage 132_m. The processor 131 may store data in the first high bandwidth storage 132_1 to the m^{th} high bandwidth storage 132_m or may read data stored in the first high bandwidth storage 132_1 to the m^{th} high bandwidth storage 132_m. As described above with reference to the drawings, the first high bandwidth storage 132_1 to the m^{th} high bandwidth storage 132_m may be set to one of a plurality of modes and may provide variable input/output according to the mode. Accordingly, the first high bandwidth storage 132_1 to the m^{th} high bandwidth storage 132_m may efficiently support not only sequential access but also random access to the processor 131.

As described above, example embodiments are disclosed in the drawings and the specification. Although specific terms are used to describe example embodiments, such usage is merely for the purpose of describing the technical scope of the present disclosure and is not intended to limit the meaning or restrict the scope of the disclosure.

## Claims

1. A memory device comprising:
an input/output buffer (26) configured to receive or output first data in a first mode and receive or output second data and third data in a second mode;
a control circuit (28) configured to obtain a first command-address in the first mode and obtain a second command-address and a third command-address in the second mode; and
at least one first pin (27) connected to the input/output buffer (26) and configured to receive or output at least one bit of the first data in the first mode and receive at least one bit of the third command-address in the second mode.

2. The memory device of claim 1, further comprising a plurality of first pins (27) including the at least one first pin and configured to receive the second command-address and the third command-address in parallel in the second mode.

3. The memory device of claim 2, further comprising a plurality of second pins (27) connected to the input/output buffer (26) and configured to receive or output at least a portion of the first data in the first mode and sequentially receive or output the second data and the third data in the second mode.

4. The memory device of claim 3, wherein the input/output buffer (26) is configured to receive or output fourth data to seventh data in a third mode,
wherein:
the control circuit (28) is configured to obtain a fourth command-address to a seventh command-address in the third mode, and
the plurality of second pins (27) comprise at least one second pin configured to receive at least one bit of the seventh command-address in the third mode.

5. The memory device of claim 3 or 4, wherein:
the plurality of second pins (27) comprise:
at least one second pin configured to receive or output the second data in the second mode; and
at least one second pin configured to receive or output the third data in the second mode.

6. The memory device of any one of claims 2 to 5, wherein the plurality of first pins (27) comprise at least one first pin configured to receive at least one bit of the first command-address in the first mode and receive at least one bit of the second command-address in the second mode.

7. The memory device of any one of claims 2 to 6, further comprising at least one third pin (27) configured to receive the first command-address in the first mode.

8. The memory device of any preceding claim, wherein the input/output buffer (26) is configured to, through the at least one pin (27) in the first mode, receive at least one bit of the first command-address during a first period and receive or output at least one bit of the first data during a second period.

9. The memory device of any preceding claim, further comprising at least one fourth pin (27) configured to receive a mode signal,
wherein the control circuit (28) is configured to identify one of the first mode and the second mode based on the mode signal.

10. The memory device of any preceding claim, wherein the control circuit (28) is configured to identify the first mode based on a first command and identify the second mode based on a second command.

11. A method performed by a memory device, the method comprising:
receiving (S12) a first command-address in a first mode;
receiving or outputting (S13) first data based on the first command-address in the first mode;
receiving (S14) a second command-address and a third command-address in a second mode; and
receiving or outputting (S15) second data and third data based on the second command-address and the third command-address in the second mode,
wherein:
the receiving or outputting of the first data comprises receiving or outputting at least one bit of the first data through at least one first pin, and
the receiving of the second command-address and the third command-address comprises receiving at least one bit of the third command-address through the at least one first pin.

12. The method of claim 11, wherein the receiving of the second command-address and the third command-address comprises receiving, through a plurality of first pins including the at least one first pin, the second command-address and the third command-address in parallel in the second mode.

13. The method of claim 12, wherein:
the receiving or outputting of the first data comprises receiving or outputting at least a portion of the first data through a plurality of second pins, and
the receiving or outputting of the second data and the third data comprises sequentially receiving or outputting the second data and the third data through the plurality of second pins.

14. The method of claim 13, further comprising:
receiving (S16) a fourth command-address to a seventh command-address in a third mode; and
receiving or outputting (S17) fourth data to seventh data based on the fourth command-address to the seventh command-address in the third mode,
wherein the receiving of the fourth command-address to the seventh command-address comprises receiving at least one bit of the seventh command-address through at least one of the plurality of second pins.

15. The method of claim 13 or 14, wherein:
the receiving or outputting of the first data comprises receiving or outputting at least a portion of the first data through the plurality of second pins, and
the receiving or outputting of the second data and the third data in the second mode comprises:
receiving or outputting the second data through at least one of the plurality of second pins; and
receiving or outputting the third data through at least another one of the plurality of second pins.
